# EUROPEAN PATENT APPLICATION

(11) **EP 3 396 013 A1**
(43) Date of publication of application: **31.10.2018**
(21) Application number: 16878442.9
(22) Date of filing: 12.12.2016
(51) Int. Cl.: C23C 14/08, C04B 35/00, C23C 14/34, H01B 5/14, H01B 13/00

(54) **TRANSPARENT CONDUCTIVE FILM, SUBSTRATE PROVIDED WITH TRANSPARENT CONDUCTIVE FILM, AND METHOD FOR PRODUCING SUBSTRATE PROVIDED WITH TRANSPARENT CONDUCTIVE FILM**

(30) Priority: 24.12.2015 JP 2015251989
(71) Applicant: Nippon Electric Glass Co., Ltd., Otsu-shi, Shiga 520-8639 (JP); Oled Material Solutions Co., Ltd., Higashiomi-shi, Shiga 521-1295 (JP)
(72) Inventor: IMURA Masaaki, Otsu-shi Shiga 520-8639 (JP); SAKAMOTO Akihiko, Higashiomi-shi Shiga 521-1295 (JP)
(74) Representative: Tetzner, Michael
(86) International application number: PCT/JP2016/086897
(87) International publication number: WO 2017/110551

(57) **Abstract**

Provided is a transparent conductive film formed of an indium tin oxide film, which has a value of (carrier mobility)/(carrier concentration) of 2×10⁻²⁰ cm⁵/V/S or more and a value of (carrier mobility)×(carrier concentration) of 200×10²⁰ cm⁻¹/V/S or more.

## Description

### Technical Field

The present invention relates to a transparent conductive film formed of an indium tin oxide (ITO) film.

### Background Art

A transparent conductive film formed of an ITO film is utilized in various fields including OLED lighting.

An OLED lighting device has a structure in which a voltage is applied to an OLED light-emitting layer between a first electrode formed of a transparent conductive film and a second electrode formed of a metal film to cause the OLED light-emitting layer to emit light. The light emitted by the OLED light-emitting layer is extracted to an outside of the OLED lighting device through the transparent conductive film, and is utilized as light for lighting a predetermined target object.

In this connection, the OLED lighting device is required to light what a user wants to see, unlike a device in which the user directly sees a light source, such as a display device. Therefore, the OLED lighting device is required to have higher brightness than the display.

Accordingly, the transparent conductive film to be used for OLED lighting is required to have a low resistance and a low light absorptance.

Herein, as a transparent conductive film in consideration of achieving a reduction in resistance and the like, there are given, for example, transparent conductive films disclosed in Patent Literatures 1 and 2.

In addition, for example, in Patent Literature 3, there is a disclosure that, in order to increase light extraction efficiency in OLED lighting, a light scattering layer (a layer of vitreous material (3)) is arranged between a glass substrate (a glass substrate (10)) and a transparent electrode film (an electrode layer (5)).

### Citation List

Patent Literature 1: JP 2010-177161 A
Patent Literature 2: JP 2013-216925 A
Patent Literature 3: JP 2013-518361 A

### Summary of Invention

### Technical Problem

However, in each of the transparent conductive films disclosed in Patent Literatures 1 and 2, a reduction in resistance and a reduction in light absorptance are insufficient for use in applications including OLED lighting.

In particular, it becomes difficult to respond to the case in which the light scattering layer is used, as disclosed in, for example, Patent Literature 3. Specifically, in the case in which the light scattering layer is used, light is repetitively reflected in the OLED lighting device (between the light scattering layer and the metal electrode film), and hence absorption of light by the transparent conductive film has a larger influence. Accordingly, the transparent conductive film is required to achieve both a reduction in resistance and a reduction in light absorptance at higher levels.

An object of the present invention is to provide a transparent conductive film which is reduced in resistivity and light absorptance to the extent possible, and a substrate with a transparent conductive film.

### Solution to Problem

According to one embodiment of the present invention, which has been devised in order to achieve the above-mentioned object, there is provided a transparent conductive film formed of an indium tin oxide film, which has a value of (carrier mobility)/(carrier concentration) of 2×10⁻²⁰ cm⁵/V/S or more and a value of (carrier mobility)×(carrier concentration) of 200×10²⁰ cm⁻¹/V/S or more.

Specifically, as a result of extensive investigations, the inventors of the present invention have found that the light absorptance of an ITO film is reduced when a value of (carrier mobility)/(carrier concentration) is increased. In addition, it is generally known that the resistivity of the ITO film is reduced when a value of (carrier mobility)×(carrier concentration) is increased. Further, the inventors have attained the following result: when those values fall within the above-mentioned numerical ranges, both a reduction in resistance and a reduction in light absorptance can be achieved at the same time at such high levels that no problem arises even for use in OLED lighting and the like.

In the above-mentioned configuration, the transparent conductive film preferably has a value of (carrier mobility)/(carrier concentration) of 3.6×10⁻²⁰ cm⁵/V/S or more. With this, the light absorptance of the ITO film can be reduced more.

According to one embodiment of the present invention, which has been devised in order to achieve the above-mentioned object, there is provided a substrate with a transparent conductive film, comprising, on a substrate, a light scattering layer and a transparent conductive film formed of an indium tin oxide film, wherein, when a carrier mobility of the transparent conductive film is defined as µ (cm²/V/S) and a carrier concentration of the transparent conductive film is defined as n (cm⁻³), the transparent conductive film has a value of µ/n of 2×10⁻²⁰ cm⁵/V/S or more and a value of µ×n of 200×10²⁰ cm⁻¹/V/S or more. With this, the same actions and effects as those of the above-mentioned corresponding configuration can be exhibited.

According to one embodiment of the present invention, which has been devised in order to achieve the above-mentioned object, there is provided a method of producing a substrate with a transparent conductive film, the substrate with a transparent conductive film comprising a transparent conductive film formed of an indium tin oxide film on a substrate, the method comprising arranging the substrate in a chamber including an indium tin oxide target, and performing sputtering under a state in which an oxygen concentration in the chamber is set to from 0.5% to 0.9%.

Specifically, as a result of extensive investigations, the inventors of the present invention have found that, when the sputtering is performed by setting the oxygen concentration in the chamber higher (an oxygen concentration of 0.5% or more) than the normal value, the light absorptance of a transparent conductive film to be produced is reduced, that is, a value of (carrier mobility)/(carrier concentration) is increased. Meanwhile, the inventors have also found that, when the oxygen concentration in the chamber is excessively increased (an oxygen concentration of more than 0.9%), the sheet resistance of an ITO film has a large variation, and the ITO film cannot achieve a sufficient reduction in resistance in its entirety, that is, a value of (carrier mobility)×(carrier concentration) is not sufficiently increased. Further, the inventors have attained the following result: when the oxygen concentration in the chamber is set within the above-mentioned numerical range, a substrate with a transparent conductive film having a value of (carrier mobility)/(carrier concentration) of 2×10⁻²⁰ cm⁵/V/S or more and a value of (carrier mobility)×(carrier concentration) of 200×10²⁰ cm⁻¹/V/S or more can be produced.

### Advantageous Effects of Invention

As described above, according to the present invention, the transparent conductive film which is reduced in resistivity and light absorptance to the extent possible, and the substrate with a transparent conductive film can be provided.

### Brief Description of Drawings

FIG. 1 is a conceptual diagram for showing a relationship between an oxygen amount in a chamber and a sheet resistance of an ITO film.
FIG. 2 is a graph for showing a relationship between a carrier concentration and a carrier mobility.
FIG. 3 is a graph for showing a relationship between a value of (carrier mobility)/(carrier concentration) and a light absorption degree.
FIG. 4 is a graph for showing a relationship between a light absorptance of an ITO film in the case in which a light scattering layer is not included and a light absorptance of the ITO film in the case in which a light scattering layer is included.
FIG. 5 is a sectional view for illustrating an example of an OLED lighting device.

### Description of Embodiments

Now, an OLED lighting device in which a substrate with a transparent conductive film according to an embodiment of the present invention is incorporated is described.

An OLED lighting device in which a substrate with a transparent conductive film according to an embodiment of the present invention is incorporated comprises, for example, a glass substrate serving as a substrate, a light scattering layer, a smooth layer, a transparent conductive film serving as a first electrode, an OLED light-emitting layer, and a metal film serving as a second electrode in the stated order. Of those, the glass substrate, the light scattering layer, the smooth layer, and the transparent conductive film correspond to the substrate with a transparent conductive film according to this embodiment.

Soda glass, alkali-free glass, or the like is used for the glass substrate. The glass substrate is formed by an overflow down-draw method, a float method, or the like. The glass substrate has a thickness of, for example, from 0.3 mm to 2 mm. The glass substrate has a refractive index of, for example, from 1.5 to 1.7.

The light scattering layer has, for example, a structure with irregularities formed on a surface of the glass substrate. The light scattering layer having the structure with irregularities is formed, for example, by screen printing a glass paste on the surface of the glass substrate. The light scattering layer has a thickness of, for example, from 1 µm to 10 µm. The light scattering layer has a refractive index of, for example, from 1.4 to 1.7, but in this embodiment, has a refractive index which matches the refractive index of the glass substrate. The light scattering layer is not particularly limited as long as the light scattering layer has a function of scattering light, and for example, may have a structure in which a substance having a light scattering property (e.g., TiO₂) is dispersed in a smooth layer.

The smooth layer plays a role in smoothening a surface of the light scattering layer having the structure with irregularities. The smooth layer is formed, for example, by applying a glass paste onto the light scattering layer. The smooth layer has a thickness of, for example, from 5 µm to 50 µm. The smooth layer has a refractive index of, for example, from 1.7 to 2.1, but in this embodiment, has a refractive index which matches the refractive index of the transparent conductive film. When the light scattering layer is formed of a smooth layer, the smooth layer may be omitted.

The transparent conductive film is formed of an ITO film. The transparent conductive film is formed by a vacuum deposition method, a sputtering method, or the like. The transparent conductive film has a thickness of, for example, from 20 nm to 350 nm. The transparent conductive film has a refractive index of, for example, from 1.7 to 2.1. In this embodiment, the transparent conductive film has a refractive index higher than the refractive index of the glass substrate.

The OLED light-emitting layer has a single layer structure or a multi-layer structure. The OLED light-emitting layer is formed by a vacuum deposition method, a spin coating method, a cast method, or the like. The OLED light-emitting layer has a thickness of, for example, from 20 nm to 200 nm.

The metal film is formed of an Al film or the like. The metal film is formed by a vacuum deposition method, a sputtering method, or the like. The metal film has a thickness of, for example, from 50 nm to 200 nm.

With the above-mentioned configuration, a voltage is applied to the OLED light-emitting layer between the transparent conductive film and the metal film to cause the OLED light-emitting layer to emit light. The light emitted is allowed to pass through the transparent conductive film and is scattered in the light scattering layer. Thus, the light is extracted on a glass substrate side, and a predetermined target object or the like is lighted therewith.

In addition, in the case of the OLED lighting device comprising the light scattering layer as described above, the light emitted by the OLED light-emitting layer is scattered in the light scattering layer and diffuses in various directions, and hence the amount of a light component which is repetitively reflected between the light scattering layer and the metal film is increased. As a result, absorption of light by the transparent conductive film between the light scattering layer and the metal film has a large influence on the characteristics of the OLED lighting device.

In view of the foregoing, the transparent conductive film has the following characteristics.

Specifically, the transparent conductive film has a value of (carrier mobility)/(carrier concentration) of 2×10⁻²⁰ cm⁵/V/S or more. The value of (carrier mobility)/(carrier concentration) is preferably 3.2×10⁻²⁰ cm⁵/V/S or more, more preferably 3.6×10⁻²⁰ cm⁵/V/S or more. When the value of (carrier mobility)/(carrier concentration) is increased, the light absorptance of the transparent conductive film is reduced. In addition, when the value of (carrier mobility)/(carrier concentration) is 2×10⁻²⁰ cm⁵/V/S or more, the light absorptance of the transparent conductive film 4 is reduced to such extent that no problem arises even for use in the OLED lighting device comprising the light scattering layer.

In addition, the transparent conductive film has a value of (carrier mobility)×(carrier concentration) of 200×10²⁰ cm⁻¹/V/S or more. The value of (carrier mobility)×(carrier concentration) is preferably 350×10²⁰ cm⁻¹/V/S or more. In addition, the value of (carrier mobility)×(carrier concentration) is preferably 505×10²⁰ cm⁻¹/V/S or less. When the value of (carrier mobility)×(carrier concentration) is increased, the resistivity of the transparent conductive film is reduced. In addition, when the value of (carrier mobility)×(carrier concentration) is 200×10²⁰ cm⁻¹/V/S or more, the resistivity of the transparent conductive film is reduced to such extent that no problem arises even for use in the OLED lighting device comprising the light scattering layer.

Herein, the transparent conductive film preferably has a value of (carrier mobility)/(carrier concentration) of 3.6×10⁻²⁰ cm⁵/V/S or more and a value of (carrier mobility)×(carrier concentration) of 200×10²⁰ cm⁻¹/V/S or more. In addition, the transparent conductive film may have a value of (carrier mobility)/(carrier concentration) of 2×10⁻²⁰ cm⁵/V/S or more and 505×10⁻²⁰ cm⁵/V/S or less and a value of (carrier mobility)×(carrier concentration) of 200×10²⁰ cm⁻¹/V/S or more.

Next, an example of a method of producing an OLED lighting device in which the substrate with a transparent conductive film having the above-mentioned configuration is incorporated is described. In the production method, a method of producing the substrate with a transparent conductive film is also described.

### (Scattering Layer Formation Step)

First, a soda glass substrate is prepared as a glass substrate. Next, a zinc borate-based glass paste is screen printed on the glass substrate, and dried under an air atmosphere. After that, the glass paste is fired under an air atmosphere. Thus, a light scattering layer formed of glass is formed on the glass substrate. The glass substrate and the light scattering layer each have a refractive index of 1.6.

### (Smooth Layer Formation Step)

Subsequently, a bismuth-based glass paste is applied onto the light scattering layer with an applicator, and dried under an air atmosphere. After that, the glass paste is fired under an air atmosphere. Thus, a smooth layer formed of glass is formed on the light scattering layer. The smooth layer has a refractive index of 1.9.

### (Transparent Conductive Film Formation Step)

After that, a transparent conductive film formed of an ITO film is formed on the smooth layer by a sputtering method. During sputtering, the glass substrate having formed thereon the light scattering layer and the smooth layer, and an indium tin oxide target (film forming material) are arranged in a chamber of a sputtering device. Under such state, a mixed gas of argon and oxygen is supplied as a reactive gas to the chamber. The glass substrate has a temperature of from 150°C to 350°C during the sputtering.

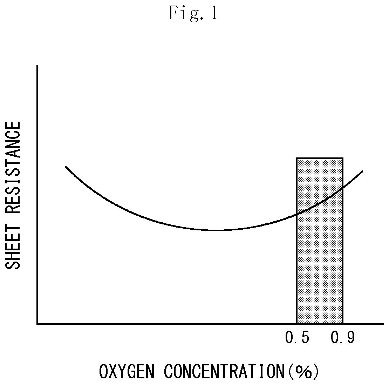

In this case, an oxygen concentration in the chamber is set to from 0.5% to 0.9%, preferably from 0.6% to 0.8%. Herein, as shown in FIG. 1, in the case in which the oxygen concentration in the chamber is low and in the case in which the oxygen concentration in the chamber is high, a sheet resistance curve of the transparent conductive film 4 tends to have a large inclination. That is, a sheet resistance tends to have a large change with a slight change in oxygen concentration. Meanwhile, when the oxygen concentration in the chamber falls between those cases (from 0.2% to 0.5%), the sheet resistance curve of the transparent conductive film 4 tends to have a small inclination. That is, the sheet resistance shows little change with a slight change in oxygen concentration. Accordingly, in general, the transparent conductive film is formed in an oxygen concentration range of from 0.2% to 0.5% so that a variation in sheet resistance is reduced. However, in this embodiment, the oxygen concentration in the chamber is set to as high as 0.5% or more based on the finding that, when the oxygen concentration in the chamber is increased, the light absorptance of a transparent conductive film to be produced is reduced. In addition, the oxygen concentration in the chamber is set to 0.9% or less because, when the oxygen concentration in the chamber is excessively increased, the sheet resistance of the transparent conductive film has an excessively large variation as described above.

Through the sputtering under the above-mentioned conditions, a transparent conductive film having a value of (carrier mobility)/(carrier concentration) of 3.6×10⁻²⁰ cm⁵/V/S or more and a value of (carrier mobility)×(carrier concentration) of 200×10²⁰ cm⁻¹/V/S or more is formed.

The transparent conductive film has a refractive index of 1.9.

### (OLED Light-emitting Layer Formation Step and Metal Film Formation Step)

Next, an OLED light-emitting layer is formed on the transparent conductive film by a vacuum deposition method. After that, a metal film is formed on the OLED light-emitting layer by a vacuum deposition method.

### Examples

In each of Examples 1 to 8 of the present invention, a substrate with an ITO film was produced by forming an ITO film on a glass substrate by a sputtering method. During sputtering, the glass substrate had a temperature of 350°C, and an oxygen concentration in a chamber was appropriately adjusted in a range of from 0.5% to 0.9%.

In addition, in Comparative Example 1, the production conditions are substantially the same as those in Examples 1 to 8 except for the oxygen concentration in the chamber.

The substrates with an ITO film of Examples 1 to 8 and Comparative Example 1 thus produced were evaluated for various characteristics, and the evaluation results are shown in Table 1. In Table 1, corresponding data in Patent Literature 1 and Patent Literature 2 are shown as Comparative Examples 2 to 11. In each of Comparative Examples 9 to 11, the resistivity is determined through calculation from a value of the carrier concentration and a value of the carrier mobility.

**Table 1**

| | Film thickness (nm) | Sheet resistance (Ω/) | Resistivity (×10⁻⁴ Ω·cm) | Carrier concentration n (×10²⁰ cm⁻³) | Carrier mobility µ (cm²/V/S) | µ/n (×10⁻²⁰ cm⁵/V/S) | nµ (×10²⁰ cm⁻¹/V/S) | Light absorptance (%) | Light absorption degree (%) | Sputtering power (kW) | Oxygen concent ration (%) |
|---|---|---|---|---|---|---|---|---|---|---|---|
| Example 1 | 96.3 | 17.8 | 1.72 | 8.6 | 42.1 | 4.9 | 363.3 | 0.70 | 0.73 | 3.9 | 0.68 |
| Example 2 | 103.4 | 15.0 | 1.55 | 9.6 | 42.1 | 4.4 | 402.1 | 0.90 | 0.87 | 6.2 | 0.68 |
| Example 3 | 93.9 | 13.5 | 1.26 | 11.8 | 41.7 | 3.5 | 492.1 | 1.16 | 1.24 | 7.2 | 0.68 |
| Example 4 | 161.7 | 8.3 | 1.33 | 13.5 | 34.7 | 2.6 | 468.5 | 3.04 | 1.88 | 12.6 | 0.68 |
| Example 5 | 99.0 | 14.4 | 1.43 | 10.7 | 40.8 | 3.8 | 436.6 | 0.96 | 0.97 | 3.9 | 0.54 |
| Example 6 | 99.6 | 13.6 | 1.36 | 11.0 | 41.9 | 3.8 | 460.9 | 1.02 | 1. 02 | 6 | 0.54 |
| Example 7 | 143.1 | 9.8 | 1.41 | 14.2 | 31.2 | 2.2 | 443.0 | 2.95 | 2.06 | 11.1 | 0.54 |
| Example 8 | 103.7 | 10.8 | 1.12 | 16.4 | 34.0 | 2.1 | 557.6 | 2.22 | 2.14 | 8.2 | 0.54 |
| Comparative Example 1 | 96.6 | 12.8 | 1.23 | 17.0 | 29.9 | 1.8 | 508.3 | 2.87 | 2.97 | 5.9 | 0.14 |
| Comparative Example 2 (JP 2010-177161 A, Example 1-1) | 200 | 26.9 | 5.37 | 6.8 | 17.0 | 2.5 | 115.8 | | | | 1.50 |
| Comparative Example 3 (JP 2010-177161 A, Example 1-2) | 200 | 26.0 | 5.19 | 5.7 | 21.2 | 3.7 | 120.4 | | | | 1.50 |
| Comparative Example 4 (JP 2010-177161 A, Example 1-3) | 200 | 24.6 | 4.92 | 7.6 | 16.8 | 2.2 | 127.2 | | | | 1.50 |
| Comparative Example 5 (JP 2010-177161 A, Example 2) | 200 | 24.8 | 4.96 | 6.8 | 18.5 | 2.7 | 126.2 | | | | 1.00 |
| Comparative Example 6 (JP 2010-177161 A, Comparative Example 1) | 200 | 64.0 | 12.80 | 2.0 | 24.8 | 12.7 | 48.6 | | | | 1.50 |
| Comparative Example 7 (JP 2010-177161 A, Comparative Example 2) | 200 | 42.2 | 8.44 | 3.5 | 21.3 | 6.1 | 73.9 | | | | 1.50 |
| Comparative Example 8 (JP 2010-177161 A, Comparative Example 3) | 200 | 96.5 | 19.30 | 1.2 | 27.1 | 22.6 | 32.5 | | | | 1.00 |
| Comparative Example 9 (JP 2013-216925 A, Example 1) | 300 | 5.16 | 1.25 | 22.7 | 22.0 | 1.0 | 499.4 | | | | |
| Comparative Example 10 (JP 2013-216925 A, Comparative Example 1) | 300 | 6.23 | 1.29 | 25.7 | 18.8 | 0.7 | 483.2 | | | | |
| Comparative Example 11 (JP 2013-216925 A, Comparative Example 2) | 300 | 6.67 | 1.31 | 25.7 | 18.5 | 0.7 | 475.5 | | | | |

In each of Examples 1 to 8 and Comparative Example 1 in Table 1, the film thickness was measured with Dektak 6M manufactured by Veeco Instruments Inc., the sheet resistance was measured with MCP-T360 manufactured by Mitsubishi Chemical Analytech Co., Ltd., and the resistivity, the carrier concentration (n), and the carrier mobility (µ) were measured with ResiTest 8320 manufactured by TOYO Corporation.

In each of Examples 1 to 8 and Comparative Example 1 in Table 1, the light absorptance of the ITO film was measured as described below. Luminous transmittances and luminous reflectances in the following items 1, 2, 4, and 5 were measured with U-4100 manufactured by Hitachi, Ltd. or UV-3100PC manufactured by Shimadzu Corporation.
1. A luminous transmittance (A) of a substrate with an ITO film is measured by a method in conformity with ISO 9050 [measurement wavelength: from 380 nm to 780 nm, standard light source: D65].
2. A luminous reflectance (B) of the substrate with an ITO film is measured by a method in conformity with ISO 9050 [measurement wavelength: from 380 nm to 780 nm, standard light source: D65].
3. A light absorptance (C) of the substrate with an ITO film =100%-(A)-(B)
4. A luminous transmittance (D) of a substrate without an ITO film is measured by a method in conformity with ISO 9050 [measurement wavelength: from 380 nm to 780 nm, standard light source: D65].
5. A luminous reflectance (E) of the substrate without an ITO film is measured by a method in conformity with ISO 9050 [measurement wavelength: from 380 nm to 780 nm, standard light source: D65].
6. A light absorptance (F) of the substrate without an ITO film =100%-(D)-(E)
7. A light absorptance (G) of an ITO film =(C)-(F)

In each of Examples 1 to 8 and Comparative Example 1 in Table 1, the light absorptance depends on the film thickness. That is, when the film thickness is increased, the light absorptance is inevitably increased. Therefore, a value of the light absorptance normalized to a value per 100 nm of film thickness was used as a light absorption degree.

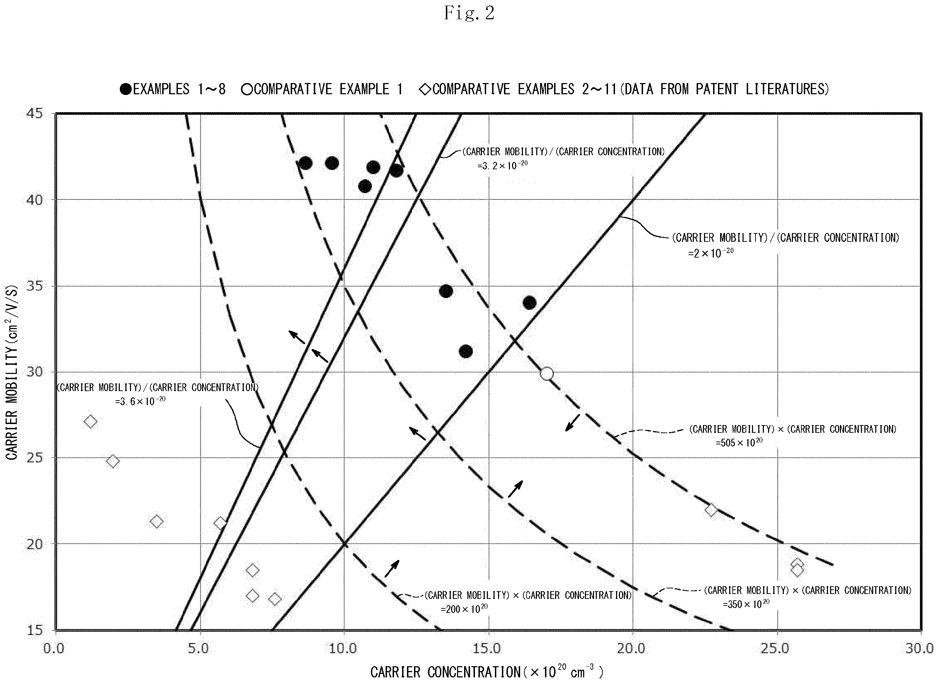

Next, a relationship between the carrier concentration and the carrier mobility in each of Examples 1 to 8 and Comparative Examples 1 to 11 in Table 1 is shown in FIG. 2.

From FIG. 2, it can be confirmed that Examples 1 to 8 fall within a range in which a value of (carrier mobility)/(carrier concentration) is 2×10⁻²⁰ cm⁵/V/S or more and a value of (carrier mobility) × (carrier concentration) is 200×10²⁰ cm⁻¹/V/S or more, and Comparative Examples 1 to 11 deviate from the range. In addition, from Table 1, it is apparent that, in each of Examples 1 to 8, the resistivity is 1.72×10⁻⁴ (Ω·cm) or less and the light absorption degree is 2.14% or less. In contrast, in Comparative Example 1, the resistivity is 1.23×10⁻⁴ (Ω·cm) and the light absorption degree is 2.97%. That is, in Comparative Example 1, the resistivity is low, but the light absorption degree is high. However, in each of Examples 1 to 8, a satisfactory result that both the resistivity and the light absorption degree are low is obtained. In the case of OLED lighting, it is considered that the light absorption degree has a larger influence on the characteristics than the resistivity.

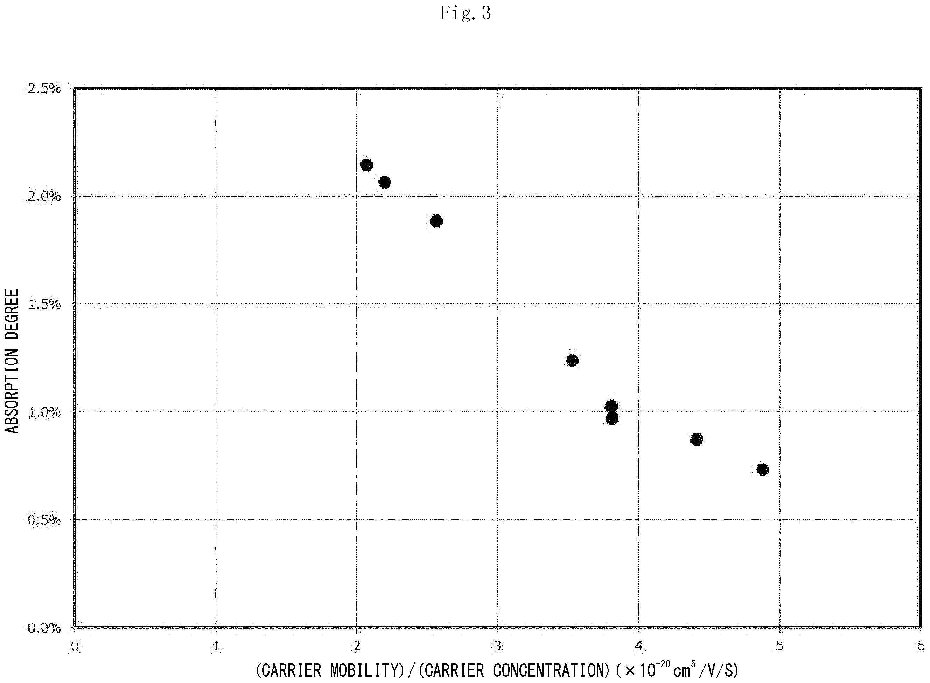

Further, a relationship between the value of (carrier mobility)/(carrier concentration) and the light absorption degree in each of Examples 1 to 8 in Table 1 is shown in FIG. 3.

From FIG. 3, it can be recognized that the light absorption degree becomes lower with an increase in value of (carrier mobility)/(carrier concentration). That is, it can be recognized that the value of (carrier mobility)/(carrier concentration) is useful as a parameter for evaluating the light absorption degree.

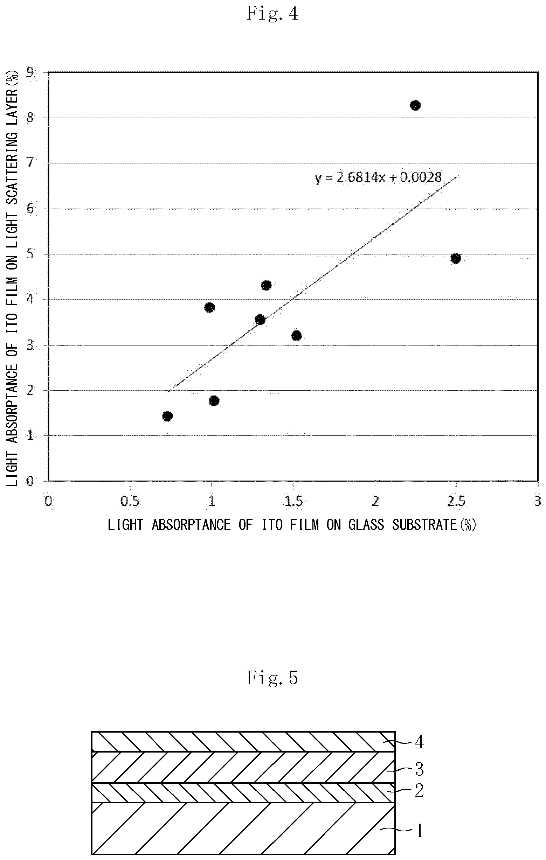

Now, a relationship between the light absorptance of an ITO film in the case in which a light scattering layer is not included (abscissa) and the light absorptance of the ITO film in the case in which a light scattering layer is included (ordinate) is shown in FIG. 4.

From FIG. 4, it can be recognized that, when the light absorptance of the ITO film is reduced in a substrate with a transparent conductive film (without a light scattering layer) comprising a glass substrate and the ITO film, the light absorptance of the ITO film is also reduced in a substrate with a transparent conductive film (with a light scattering layer) comprising a glass substrate, a light scattering layer, and the ITO film. Accordingly, the results obtained through the above-mentioned evaluation tests using the substrate with a transparent conductive film comprising the glass substrate and the ITO film also apply to the case in which a light scattering layer is arranged. That is, it is apparent that, when the ITO film has a value of (carrier mobility)/(carrier concentration) and a value of (carrier mobility)×(carrier concentration) falling within a range of 2×10⁻²⁰ cm⁵/V/S or more and a range of 200×10²⁰ cm⁻¹/V/S or more, respectively, both the resistivity and the light absorptance (or the light absorption degree) of the ITO film are reduced even in the case of a substrate with a transparent conductive film comprising a light scattering layer.

The embodiment of the present invention has been described above, but it should be appreciated that the OLED lighting device and the method of producing the same described above may adopt any modes within the scope of the present invention.

In the above-mentioned embodiment, for example, the case in which the present invention is applied to an OLED lighting device comprising a light scattering layer has been described, but the transparent conductive film and the substrate with a transparent conductive film according to the present invention may be applied to an OLED lighting device without a light scattering layer. That is, as illustrated in FIG. 5, the OLED lighting device may comprise a glass substrate 1, a transparent conductive film 2, an OLED light-emitting layer 3, and a metal film 4. In this case, the glass substrate 1 and the transparent conductive film 2 correspond to the substrate with a transparent conductive film.

In addition, in the above-mentioned embodiment, the case in which the present invention is applied to an OLED lighting device has been described, but the transparent conductive film and the substrate with a transparent conductive film according to the present invention may be applied to a display device and the like.

### Reference Signs List

- 1: glass substrate

- 2: transparent conductive film (first electrode)
- 3: OLED light-emitting layer
- 4: metal film (second electrode)

## Claims

1. A transparent conductive film formed of an indium tin oxide film, which has a value of (carrier mobility)/(carrier concentration) of 2×10⁻²⁰ cm⁵/V/S or more and a value of (carrier mobility)×(carrier concentration) of 200×10²⁰ cm⁻¹/V/S or more.

2. The transparent conductive film according to claim 1, wherein the transparent conductive film has a value of (carrier mobility)/(carrier concentration) of 3.6×10⁻²⁰ cm⁵/V/S or more.

3. A substrate with a transparent conductive film, comprising, on a substrate, a light scattering layer and a transparent conductive film formed of an indium tin oxide film,
wherein, when a carrier mobility of the transparent conductive film is defined as µ (cm²/V/S) and a carrier concentration of the transparent conductive film is defined as n (cm⁻³), the transparent conductive film has a value of µ/n of 2×10⁻²⁰ cm⁵/V/S or more and a value of µ×n of 200×10²⁰ cm⁻¹/V/S or more.

4. A method of producing a substrate with a transparent conductive film, the substrate with a transparent conductive film comprising a transparent conductive film formed of an indium tin oxide film on a substrate,
the method comprising arranging the substrate in a chamber including an indium tin oxide target, and performing sputtering under a state in which an oxygen concentration in the chamber is set to from 0.5% to 0.9%.
